# EUROPEAN PATENT SPECIFICATION

(11) **EP 2 267 195 B1**
(45) Date of publication and mention of the grant of the patent: **08.06.2016**
(21) Application number: 09722464.6
(22) Date of filing: 18.03.2009
(51) Int. Cl.: C30B 29/36, C30B 23/06, C30B 23/00

(54) **METHOD FOR PRODUCING SILICON CARBIDE SINGLE CRYSTAL**
VERFAHREN ZUR HERSTELLUNG EINES SILICIUMCARBID-EINKRISTALLS
PROCÉDÉ DE FABRICATION D'UN MONOCRISTAL DE CARBURE DE SILICIUM

(30) Priority: 21.03.2008 JP 2008074358; 16.03.2009 JP 2009063529
(43) Date of publication of application: 29.12.2010
(73) Proprietor: Bridgestone Corporation, Tokyo 104-8340 (JP)
(72) Inventor: Ishihara, Hidetoshi, Tokyo 187-8531 (JP); Motoyama, Tsuyoshi, Tokyo 187-8531 (JP); Kondo, Daisuke, Tokyo 187-8531 (JP); Kumagai, Sho, Tokyo 187-8531 (JP)
(74) Representative: Oxley, Robin John George
(86) International application number: PCT/JP2009/055313
(87) International publication number: WO 2009/116581

(56) References cited:
- JP-A- 2001 139 394
- JP-A- 2006 143 511
- JP-A- 2006 347 868
- JP-A- 2006 347 868
- JP-A- 2008 044 802

## Description

### TECHNICAL FIELD

The present invention relates to a method for producing a silicon carbide single crystal.

### BACKGROUND ART

Silicon carbide shows a larger band gap and is excellent in dielectric breakdown property, heat resistance, radiation resistance and the like as compared with silicon. Therefore, silicon carbide has been noticed as an electronic device material for small-size high output semiconductors and the like, or as an optical device material owing to its excellent optical property. Moreover, since the silicon carbide single crystal is excellent in optical property, the silicon carbide single crystal has been noticed as an optical device material.

An example of a method for producing such a silicon carbide single crystal is a sublimation method as follows. Specifically, a raw material of silicon carbide is loaded in a reaction vessel of a production apparatus for a silicon carbide single crystal, and a seed crystal of silicon carbide is placed therein. The raw material of silicon carbide is heated and sublimated. The sublimated silicon carbide is re-crystallized on the surface of the seed crystal, and the crystal is grown. After the crystal growth, a silicon carbide single crystal thus obtained by the sublimation method is sliced to obtain a silicon-carbide single-crystal wafer. In this method, a seed crystal is used, and this makes it possible to control the crystal nucleation process. Moreover, the atmospheric pressure is controlled in a range of approximately 100 Pa to 15 kPa with an inert gas; thereby, the crystal growth rate and the like can be controlled with high repeatability. At present, a silicon-carbide single-crystal wafer having a diameter of 2 inches to 3 inches is cut from a silicon carbide single crystal produced by the sublimation method, and used for epitaxial thin film growth or device fabrication.

However, a seed crystal for producing a silicon-carbide single-crystal wafer often includes hollow defects such as micropipe defects. When a silicon carbide single crystal is grown on the surface of a seed crystal having such hollow defects, the hollow defects are not repaired. As a result, the hollow defects remain in the silicon-carbide single-crystal wafer, causing the wafer quality to decrease.

For this reason, before a silicon carbide single crystal is grown, silicon carbide is grown on the surface of a seed crystal using epitaxial thin film growth or the like to close micropipe defects in the seed crystal (Patent Document 1). Additionally, as another art to close micropipe defects in a seed crystal, the following technique exists. Specifically, a silicon carbide material is buried in micropipe defects in a silicon carbide single crystal. Then, the micropipe defects are saturated with a silicon carbide vapor and heated to close the micropipe defects existing in the seed crystal (Patent Document 2). JP2006-347868 disclose a method of fixing a seed crystal.
Patent Document 1: US Patent No.5679153
Patent Document 2: Japanese Unexamined Patent Application Publication No 2000-034200

### DISCLOSURE OF THE INVENTION

In the method of closing micropipe defects by epitaxial thin film growth described in Patent Document 1, an epitaxial layer has to be grown to a thickness of 20 to 75 µm or larger. For this reason, an apparatus for growing the epitaxial layer is additionally needed. Moreover, processing time for growing the epitaxial layer to a desired thickness is required. Furthermore, an epitaxial layer with an insufficient thickness not only has difficulty closing micropipe defects, but also may expose opening portions of micropipe defects again after portions of the closed micropipe defects are sublimated when a crystal is grown by the sublimation method.

Meanwhile, in the method of burying a silicon carbide material in micropipe defects and heating the micropipe defect in a silicon carbide single crystal described in Patent Document 2, an organosilicon polymer dissolved to a supercritical fluid or an alcohol suspension with ultrafine particles of silicon carbide is used for the burying of the silicon carbide material. However, the former cases needs a step performed under high-temperature, high-pressure conditions in order for the organosilicon compound to penetrate the micropipe defects under a condition of the supercritical fluid; thus, another apparatus and processing time for the step are required. Meanwhile, in the latter case, it is difficult to surely bury ultrafine particles of silicon carbide in micropipe defects. For the appropriate burying, another apparatus and processing time for the step are required.

As described above, in the conventional art, micropipe defects in a seed crystal are closed in a different step from growth for a silicon carbide single crystal. For this reason, an apparatus for the closing is additionally needed. Moreover, processing time and evaluation time is required. These may decrease the productivity of the silicon carbide single crystal, consequently causing the production cost to increase.

The present invention has been made to advantageously solve the above-described problems. An object thereof is to provide a method for producing a silicon carbide single crystal, the method enabling production of a high-quality single crystal with few defects with high productivity by advantageously closing hollow defects such as micropipe defects generated in a seed crystal without additional apparatus or processing.

A method for producing a silicon carbide single crystal including a step of, loading a sublimation-raw material into a vessel of a production apparatus for a silicon carbide single crystal, and placing a seed crystal for a silicon carbide single crystal in such a manner that the seed crystal substantially faces the sublimation-raw material, and re-crystallizing the sublimation-raw material sublimated by heating on a surface of the seed crystal to grow a silicon carbide single crystal, and the method further including applying a thermosetting resinthermosetting resin containing silicon component to a back surface of the seed crystal before the placing the seed crystal in the vessel of the production apparatus for a silicon carbide single crystal.

The silicon content ratio (100xSi/(C+Si) [molar ratio]) of the thermosetting resinthermosetting resin is 3.0 to 15.0%.

The thermosetting resinthermosetting resin containing silicon component preferably serves as an adhesive for adhering the seed crystal to the vessel.

The method for producing a silicon carbide single crystal of the present invention makes it possible to close hollow defects such as micropipe defects that have been often generated in a seed crystal without an additional, independent closing step. Thus, a high-quality silicon carbide single crystal with few defects can be produced with high productivity.

### BRIEF DESCRIPTION OF THE DRAWINGS

[Fig. 1] Fig. 1 is a schematic sectional view showing an examplar principal portion of a production apparatus for a silicon carbide single crystal according to an embodiment of the present invention.
[Fig. 2] Fig. 2 is an explanatory view for an outline of producing a silicon carbide single crystal using the production apparatus for a silicon carbide single crystal according to the embodiment of the present invention.
[Fig. 3] Fig. 3 is an explanatory view for a step of attaching a seed crystal applied thermosetting resin containing silicon component to a lid body according to the embodiment of the present invention.
[Fig. 4] Fig. 4 is a sectional view showing a state where the seed crystal is attached to the lid body according to the embodiment of the present invention.
[Fig. 5] Fig. 5 is a graph showing a closed defect ratio against a proportion of a silicon component in each thermosetting resin according to Examples of the present invention.

### BEST MODE FOR CARRYING OUT THE INVENTION

An embodiment of the present invention is described. Note that, in the following description of the drawings, the same or similar parts are denoted by the same or similar reference numerals. It should be noted, that the drawings are schematic, and that the dimensional proportions and the like are different from their actual values.

Accordingly, specific dimensions and the like should be inferred on the basis of the description below. Moreover, it goes without saying that dimensional relationships and dimensional proportions may be different from one drawing to another in some parts.

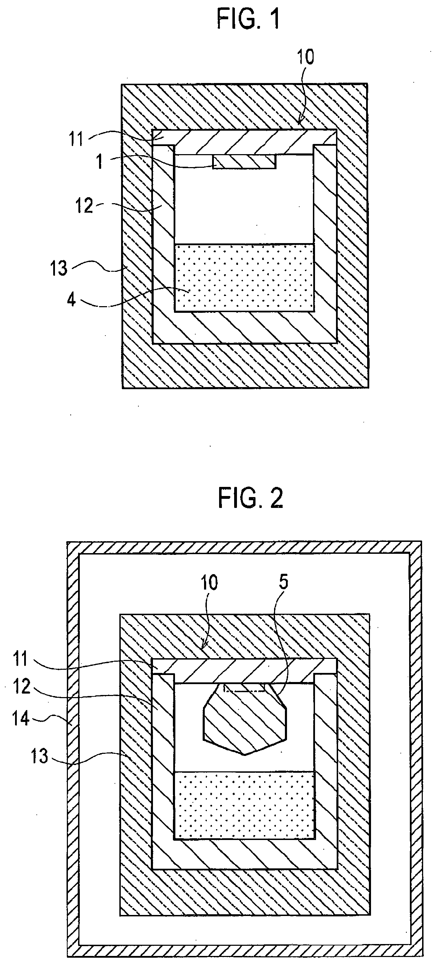

Hereinafter, a method for producing a silicon carbide single crystal of the present invention is described with reference to the drawings. Fig. 1 is a view, showing a schematic section, of an examplar principal portion of a production apparatus for a silicon carbide single crystal for carrying out the method for producing a silicon carbide single crystal of the present invention. The production apparatus for a silicon carbide single crystal shown in Fig. 1 is an apparatus for producing a silicon carbide single crystal by a sublimation method, and has a graphite crucible 10 as a vessel. The crucible 10 includes a lid body 11 at an upper part and a vessel main body 12 at a lower part. A seed crystal 1 is attached to the lid body 11. Moreover, a sublimation-raw material 4 is loaded in the vessel main body 12. A heat insulation material 13 surrounds the lid body 11 and the vessel main body 12. The heat insulation material 13 suppresses heat dissipated when the crucible 10 is heated at high temperatures, enabling the temperature in the crucible 10 to be kept high. Although unillustrated, heating means for heating the crucible 10 is provided outside the heat insulation material 13. The heating means is capable of heating the sublimation-raw material 4 to a temperature at which the sublimation-raw material 4 can be sublimated, and capable of heating the seed crystal 1 to a temperature at which the re-crystallization is possible. An example of the heating means is an induction-heating coil.

An outline of producing a silicon carbide single crystal using such a production apparatus for a silicon carbide single crystal is described with reference to Fig. 2. Note that, in Fig. 2, the same members as the members shown in Fig. 1 are denoted by the same reference numerals. The crucible 10 surrounded by the heat insulation material 13 is placed in a growth furnace 14. The sublimation-raw material 4 is loaded inside the vessel main body 12 of the crucible 10. The seed crystal 1 is attached to a central portion, on a lower surface side, of the lid body 11 in such a manner that the seed crystal 1 substantially faces the sublimation-raw material 4. The inside of the growth furnace 14 is adjusted to be an Ar gas atmosphere at a predetermined pressure. In addition, the sublimation-raw material 4 and the seed crystal 1 in the crucible 10 are heated by the unillustrated heating means so as to perform controls that the temperature of the sublimation-raw material 4 becomes a temperature at which the sublimation-raw material 4 is sublimated, and that the temperature of the seed crystal 1 becomes a temperature at which the sublimated raw material is re-crystallized on the surface of the seed crystal 1 (i.e., a temperature lower by approximately 100°C than the temperature at which the sublimation-raw material is heated). By such temperature and atmosphere controls, the sublimation-raw material 4 is sublimated in the graphite crucible 10 and re-crystallized on the surface of the seed crystal 1 which faces the sublimation-raw material 4. As a result, sublimated sublimation-raw material 4 is grown in a thickness direction and a diameter direction of the seed crystal 1. Thus, a silicon carbide single crystal 5 is obtained.

To close hollow defects such as micropipe defects generated in the seed crystal without additional apparatus and processing, the hollow defects such as micropipe defects need to be closed during a normally performed step in producing a silicon carbide single crystal.

Generally, the seed crystal 1 is attached to the lid body 11 of the crucible 10 shown in Figs. 1 and 2 as follows. Specifically, besides providing a mechanical holding device to the lid body 11, a thermosetting resin forming a thermosetting resin functioning as an adhesive is used. The thermosetting resin is applied to any one or both of the back surface of the seed crystal 1 and the lower surface of the lid body 11 of the crucible 10. The seed crystal 1 is adhered to the lid body 11 by using the thermosetting resin.

Therefore the present invention includes, before a step of placing a seed crystal in a vessel of a production apparatus for a silicon carbide single crystal, a step of applying a thermosetting resin containing silicon to component the back surface of the seed crystal, to close hollow defects such as micropipe defects. The thermosetting resin has a silicon content ratio of 3.0 to 15.0%. To suppress generation of new micropipe defects and generation of other hollow defects, the thermosetting resin further preferably has a silicon content ratio of 3.0 to 10.0%. The step of applying a thermosetting resin to the back surface of the seed crystal to close hollow defects is different from the aforementioned step of applying a thermosetting resin to help the seed crystal 1 adhere to the lid body 11 only in thermosetting resin. The way of performing the step it is the same. Thus, there is no need for an additional apparatus and a special processing.

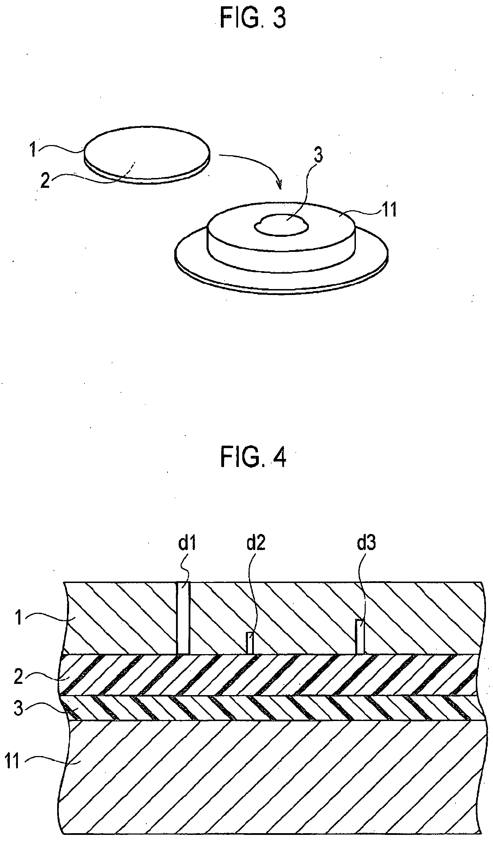

After the thermosetting resin containing silicon component is applied to the back surface of the seed crystal, the seed crystal is attached to the lid body of the crucible. Fig. 3 is an explanatory view for an example of attaching the seed crystal 1 applied thermosetting resin 2 containing silicon component to the lid body 11. In Fig. 3, the thermosetting resin 3 serving as an adhesive is applied in advance to the surface of the lid body 11. Note that, in Fig. 3, for convenience of understanding the present invention, the thermosetting resin 3 is applied only to a central portion of the surface of the lid body 11. However, the application of the thermosetting resin 3 is not limited to the example shown in figure. It is needless to say that, the thermosetting resin 3 can be applied to the surface of the lid body 11 to cover the entire back surface of the seed crystal 1, to make the seed crystal 1 surely adhere to the lid body 11. As the thermosetting resin 3, a conventionally known material such as a phenol resin can be used. For example, a Si-modified phenol resin or the like can be used as the thermosetting resin 3.

Fig. 4 shows, in a sectional view, a state the seed crystal 1 is attached to the lid body 11. The seed crystal 1 has multiple micropipe defects d1, d2, d3. The film of the thermosetting resin 2 containing silicon component is formed on the back surface of the seed crystal 1 to cover openings of these micropipe defects d1, d2, d3. Moreover, the films of the thermosetting resin 3 serving as an adhesive is formed between the lid body 11 and the thermosetting resin 2 containing silicon component.

The seed crystal 1 adhering to the lid body 11 and the lid body 11 are attached to an upper portion of the vessel main body 12 of the crucible 10 as shown in Fig. 1. Then, a heat treatment is performed on the seed crystal 1 by the unillustrated heating means. By this heat treatment, silicon carbide is produced from the thermosetting resin 2 containing silicon component in regions where the thermosetting resin 2 is formed to cover the openings of the multiple micropipe defects d1, d2, d3 generated in the seed crystal 1. Additionally, the heat treatment makes the internal space of each of the micropipe defects d1, d2, d3 have such an atmosphere and a temperature that silicon carbide can be sublimated and re-crystallized. Thus, silicon carbide produced from the thermosetting resin 2 containing silicon component is sublimated at the opening of each micropipe defect d1, d2, d3, and re-crystallized in the internal space of the corresponding micropipe defect d1, d2, d3. This makes it possible to close these micropipe defects d1, d2, d3.

### (Comparison and Evaluation)

To further clarify the effects of the present invention, described is the comparison and evaluation conducted using thermosetting resins containing silicon component according to Examples below. Specifically, the evaluation method and the evaluation result are described. It should be noted that the present invention is not limited to these examples at all.

### (Evaluation Method)

Eight kinds of thermosetting resins were prepared with different content ratio of silicon. Each of the thermosetting resins was applied on the back surface of a seed crystal, and the seed crystal was adhered to a lid body of a vessel. After the adhesion, a silicon carbide single crystal was grown. Before and after the growth of the silicon carbide single crystal, the number of micropipe defects generated in the seed crystal was counted, and the proportion of closed defects was calculated as a closed defect ratio. Moreover, the state of the micropipe defects generated in the seed crystal was observed before and after the growth of the silicon carbide single crystal.

### (Evaluation Result)

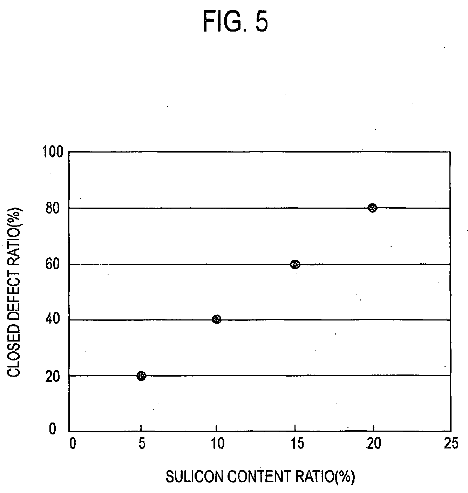

The measurement results are shown in Table 1 and Fig. 5. Fig. 5 is a graph showing the closed defect ratio corresponding to the content ratio of silicon in each thermosetting resin according to Examples of the present invention. The typical points of Examples are illustrated in the graph. Examples marked with a "*" are included by way of reference.

**[Table 1]**

| | Si / (C+Si) (molar ratio) | Closed defect ratio | Generation of new micropipe defects | Generation of other defects |
|---|---|---|---|---|
| *Example 1 | 0.1% | 0 to 10% | Present | Absent |
| *Example 2 | 1.0% | 0 to 10% | Occasionall y present | Absent |
| Example 3 | 3.0% | 20 to 70% | Absent | Absent |
| Example 4 | 5.0% | 30 to 80% | Absent | Absent |
| Example 5 | 10.0% | 50 to 80% | Absent | Absent |
| Example 6 | 15.0% | 50 to 80% | Absent | Occasionally present |
| *Example 7 | 20.0% | 50 to 80% | Absent | Present |
| *Example 8 | 30.0% | 50 to 80% | Absent | Present |

As shown in Table 1, it was recognized that the closed defect ratio is increased in accordance with the silicon content ratio. Moreover, the states of the micropipe defects remaining after the growth of the silicon carbide single crystal were observed; the insides of the micropipe defects are closed, i.e., the diameters of the micropipe defects are made smaller. Therefore, it was found out that a high-quality silicon carbide single crystal with few defects could be produced.

Note that, as shown in Table 1, the closed defect ratio is increased in accordance with the increase in the silicon content ratio; however, it was found out that, depending on the growth conditions for a silicon carbide single crystal, there is a possibility to generate other defects, and attention has to be paid accordingly.

### (Operations and Effects)

According to the above-mentioned, in the method for producing a silicon carbide single crystal of the present invention, a thermosetting resin containing silicon component is applied on the back surface of a seed crystal. Accordingly, micropipe defects can be closed by the subsequent heat treatment. Moreover, the applying the thermosetting resin containing silicon component on the back surface of the seed crystal is the same as the applying processing of a thermosetting resin to help a seed crystal adhere to a lid body. Thus, an additional apparatus and a special step (for example, an additional epitaxial step, and so forth) are not needed. Hence, a high-quality silicon carbide single crystal with few defects can be produced with high productivity.

Meanwhile, it is known from conventional art that micropipe defects can be closed by altering the growth conditions, such as the temperature and pressure, for a silicon carbide single crystal. However, since altering the growth conditions effect quality and growth rate of the silicon carbide single crystal, it takes a tremendous time to evaluate the conditions. According to the present invention, such evaluation is unnecessary, and a high-quality silicon carbide single crystal with few defects can be provided, using known growth conditions.

The thermosetting resin 2, containing silicon component, used in the method for producing a silicon carbide single crystal of the present invention, is a resin chemically containing silicon component in a thermosetting resin, which is a thermosetting resin containing Si atoms provided a silicon group, an organosilicon group, or the like. Hence, the thermosetting resin 2 is not a resin physically containing ultrafine particles of silicon carbide in a thermosetting resin. Being a resin chemically containing silicon component, the thermosetting resin 2 has excellent silicon-distribution uniformity in the thermosetting resin, and can close micropipe defects effectively. Incidentally, when the thermosetting resin physically contains ultrafine particles of silicon carbide, the diameters and the shapes of the ultrafine particles of silicon carbide differ from one another, and silicon is distributed in a predetermined range. Additionally, a partial deviation may occur, i.e., the ultrafine particles of silicon carbide are spread at a low density, for example. Consequently, it is concerned that micropipe defects are closed unevenly.

A thermosetting resin serving as a base for the thermosetting resin 2 containing silicon component is not particularly limited, as long as the thermosetting resin can form carbide by heating at high temperatures. Examples thereof include a phenol resin, a resin used as a resist for a process in fabricating semiconductor devices, and the like.

The thermosetting resin 2 containing silicon component is formed on the back surface of the seed crystal 1. The formation method is not particularly limited. For example, the thermosetting resin 2 can be applied by spin coating and the like which are the same methods generally used in semiconductor fabrication steps. Spin coating is preferable because an application film is easily applied uniformly over the entire surface of the seed crystal 1. The thickness of the thermosetting resin 2 containing silicon component on the back surface of the seed crystal 1 can be a thickness sufficient to create a holding power such that the seed crystal 1 may not be detached when the seed crystal 1 adheres to the lid body 11. However, if the thickness is too large, the seed crystal 1 may warp or crack. Specifically, the thickness can be approximately several µm to more than ten µm.

In the example shown in Figs. 3 and 4, the thermosetting resin 3 serving as an adhesive is used as means for adhere the lid body 11 to the seed crystal 1 applied the thermosetting resin 2 containing silicon component. Since the adhering means is the thermosetting resin 3, the adhesive layer can be formed with the same apparatus and step for the application and formation of the thermosetting resin 2 containing silicon component. Accordingly, a silicon carbide single crystal can be produced with high productivity. As the thermosetting resin 3, a conventionally known material can be used. Examples thereof include a phenol resin and a resist resin.

The adhering means is not limited to the thermosetting resin serving as an adhesive, and the seed crystal 1 may adhere to the lid body 11 by a mechanical holding device. In sum, in the method of the present invention, as long as the thermosetting resin 2 containing silicon component is applied near the openings of micropipe defects, the effects expected from the present invention are obtained.

The thermosetting resin 2 containing silicon component also serves as an adhesive which adhere between the seed crystal and the vessel (lid body) by appropriate selection of the material, such a thermosetting resin 2 is more preferable. This is because the step of applying the thermosetting resin 3 serving as an adhesive can be omitted, further increasing the productivity.

The heat treatment for producing silicon carbide from the thermosetting resin 2 containing silicon component may be performed with a heater other than the production apparatus for silicon carbide. However, the use of the production apparatus for silicon carbide is preferable. This is because the heat treatment with the production apparatus for silicon carbide prior to heating for crystal growth matches the gist of the present invention that hollow defects are advantageously closed without additionally apparatus and processing to thereby produce a high-quality single crystal with few defects with high productivity. The heat treatment conditions can be the same as the heat treatment conditions adopted for the thermosetting resin 3 serving as an adhesive.

When a crystal is grown from the seed crystal 1 in the production apparatus for a silicon carbide single crystal, the sublimation-raw material 4 only needs to be silicon carbide. The polytype of the crystal, the amount used, and the purity, of the raw material, a method of producing the raw material, and the like are not particularly limited, and can be appropriately selected in accordance with the usage and so forth of a silicon carbide single crystal 5 to be produced.

Examples of the polytype of the crystal of the sublimation-raw material 4 include 4H, 6H, 15R, 3C, and the like. Above all, preferable examples are 6H and the like. These are preferably used alone, but may be used in combination of two or more kinds.

The amount of the sublimation-raw material 4 used can be appropriately selected in accordance with the size of a silicon carbide single crystal 5 to be produced, the size of the crucible, and so forth.

As to the purity of the sublimation-raw material 4, the purity is preferably high from the viewpoint of preventing contamination of a polycrystal or a polytype as much as possible in a silicon carbide single crystal 5 to be produced. Specifically, the content of each impurity element is preferably 0.5 ppm or less.

The sublimation-raw material 4 may be powder or a solid obtained by sintering the powder. Since the silicon carbide powder is non-uniform in size, a desired particle size can be obtained through crushing, sieving, and the like. The average particle diameter of the silicon carbide powder is preferably 10 to 700 µm, more preferably 100 to 400 µm, when the sublimation-raw material used is in the form of powder. If the average particle diameter is smaller than 10 µm, sintering rapidly occurs at the sublimation temperature, that is, 1800°C to 2700°C, of silicon carbide for growth of a silicon carbide single crystal. This reduces the sublimated surface area, and delay the growth of a silicon carbide single crystal. Additionally, when the silicon carbide powder is loaded into the crucible, or when the pressure of the re-crystallization atmosphere is changed to adjust the growth rate, the silicon carbide powder is likely to disperse. Meanwhile, if the average particle diameter exceeds 500 µm, the specific surface area of the silicon carbide powder is reduced, the growth of a silicon carbide single crystal delay in some cases.

The heating temperature of the sublimation-raw material 4 in the crucible 10 of the production apparatus for a silicon carbide single crystal, the heating temperature of the seed crystal 1, and the atmosphere and the pressure in the crucible 10 are not particularly limited. The production conditions normally-used to produce a silicon carbide single crystal can be adopted.

As described above, it goes without saying that the present invention includes various embodiments not described herein. Accordingly, the technical scope of the present invention should only be defined by the claimed elements according to claims reasonably understood from the above description.

Note that the contents of Japanese Patent Application No. 2008-074358 (filed on March 21, 2008) and 2009-063529 (filed on March 16, 2009) are entirely incorporated herein by reference.

### INDUSTRIAL APPLICABILITY

As has been described above, a method for producing a silicon carbide single crystal according to the present invention makes it possible to produce a high-quality single crystal with few defects with high productivity by advantageously closing hollow defects such as micropipe defects generated in a seed crystal without additional apparatus and processing. Accordingly, the present invention is useful as a method for producing a silicon carbide single crystal.

## Claims

1. A method for producing a silicon carbide single crystal comprising the steps of:
loading a sublimation-raw material into a reaction vessel of a production apparatus for a silicon carbide single crystal, and placing a seed crystal for a silicon carbide single crystal in such a manner that the seed crystal substantially faces the sublimation-raw material; and
re-crystallizing the sublimation-raw material sublimated by heating on a surface of the seed crystal to grow a silicon carbide single crystal; the method further including
applying a thermosetting resin containing a silicon component to a back surface of the seed crystal before the placing the seed crystal in the reaction vessel of the production apparatus for the silicon carbide single crystal, wherein the thermosetting resin has a silicon content ratio (100xSi/(C+Si) [molar ratio])of 3.0 to 15.0%.

2. The method for producing a silicon carbide single crystal according to claim 1, wherein the thermosetting resin containing silicon component also serves as an adhesive for adhering the seed crystal to the reaction vessel.

## Patentansprüche

1. Verfahren zur Herstellung eines Siliciumcarbid-Einkristalls, umfassend die Schritte des:
Ladens eines Sublimationsrohmaterials in ein Reaktionsgefäß einer Herstellungsvorrichtung für ein Siliciumcarbid-Einkristall und Positionierens eines Impfkristalls für ein Siliciumcarbid-Einkristall derart, dass das Impfkristall im Wesentlichen dem Sublimationsrohmaterial zugekehrt ist; und
Umkristallisierens des Sublimationsrohmaterials, das durch Erhitzen auf einer Fläche des Impfkristalls sublimiert worden ist, um ein Siliciumcarbid-Einkristall zu züchten; wobei das Verfahren ferner Folgendes umfasst
das Auftragen eines Duroplastharzes, das eine Siliciumkomponente enthält, auf eine rückseitige Fläche des Impfkristalls vor dem Positionieren des Impfkristalls in dem Reaktionsgefäß der Herstellungsvorrichtung für das Siliciumcarbid-Einkristall, wobei das Duroplastharz ein Siliciumgehaltsverhältnis (100xSi/(C+Si) [Molverhältnis]) von 3,0 bis 15,0 ausweist.

2. Verfahren zur Herstellung eines Siliciumcarbid-Einkristalls nach Anspruch 1, wobei das eine Siliciumkomponente enthaltende Duroplastharz auch als Klebstoff zum Befestigen des Impfkristalls an dem Reaktionsgefäß dient.

## Revendications

1. Procédé de production d'un cristal unique de carbure de silicium comprenant les étapes de:
charge d'une matière première de sublimation dans un récipient réactionnel d'un appareil de production de cristal unique de carbure de silicium, et mise en place d'un cristal semence pour l'obtention d'un cristal unique de carbure de silicium d'une manière telle que le cristal semence fasse sensiblement face à la matière première de sublimation; et
recristallisation de la matière première de sublimation sublimée par chauffage sur une surface du cristal semence pour la croissance d'un cristal unique de carbure de silicium; le procédé comprenant en outre
l'application d'une résine thermodurcissable contenant un composant de silicium à une surface dorsale du cristal semence avant la mise en place du cristal semence dans le récipient réactionnel de l'appareil de production de cristal unique de carbure de silicium, la résine thermodurcissable ayant un rapport des teneurs en silicium (100 x Si/(C + Si) [rapport molaire]) de 3,0 à 15,0 %.

2. Procédé de production d'un cristal unique de carbure de silicium selon la revendication 1, la résine thermodurcissable contenant le composant de silicium servant également d'adhésif pour faire adhérer le cristal semence au récipient réactionnel.
